# FASCICULE DE BREVET EUROPEEN

(11) **EP 2 486 342 B1**
(45) Date de publication et mention de la délivrance du brevet: **05.12.2018**
(21) Numéro de dépôt: 10778698.0
(22) Date de dépôt: 05.10.2010
(51) Int. Cl.: H01L 31/052, F24S 30/00, H01L 31/054

(54) **DISPOSITIF DE CONCENTRATION DE RADIATIONS SOLAIRES**
VORRICHTUNG ZUR KONZENTRATION DER SONNENEINSTRAHLUNG
DEVICE FOR CONCENTRATING SOLAR RADIATION

(30) Priorité: 06.10.2009 FR 0956964
(43) Date de publication de la demande: 15.08.2012
(73) Titulaire: Solar Performance Et Developpement, 75008 Paris (FR)
(72) Inventeur: OURY, Jean-Marc, F-75007 Paris (FR); RIGAL, Vincent, F-92330 Sceaux (FR)
(74) Mandataire: Gauer, Pierre
(86) Numéro de dépôt international: PCT/FR2010/052098
(87) Numéro de publication internationale: WO 2011/042656

(56) Documents cités:
- WO-A1-02/084183
- WO-A2-2006/118912
- FR-A1- 2 531 520
- GB-A- 1 562 912
- JP-A- 11 125 765
- JP-A- 56 162 351
- JP-A- 57 049 757
- US-A- 2 967 249
- US-A- 4 986 255

## Description

La présente invention a pour objet un dispositif de concentration de radiations solaires. Le dispositif de concentration selon l'invention permet une concentration automatique des radiations solaires vers un récepteur.

De nombreuses techniques de production d'énergie solaire utilisent des dispositifs de concentration des radiations solaires vers un récepteur. Ces dispositifs permettent d'augmenter l'irradiation du récepteur et d'en réduire les coûts.

Ces dispositifs de concentration utilisent soit une concentration par réflexion, en utilisant un miroir, par exemple un miroir parabolique ou cylindro-parabolique, soit une concentration par réfraction, par exemple à l'aide de lentilles. Le récepteur recueille l'énergie solaire, qui sera utilisée sous forme de chaleur, par exemple pour une centrale thermodynamique, ou directement sous la forme de rayonnements lumineux, par exemple pour une centrale photovoltaïque. Certains de ces dispositifs sont orientés selon deux axes, d'autres selon un seul axe.

L'orientation du dispositif utilise en général des moteurs électriques, commandés par un système électronique de suivi du soleil. Il est en effet facile, à partir de l'heure et de la position géographique d'une centrale, de définir à tout moment l'orientation exacte à donner au dispositif de concentration. Il est par ailleurs souvent ajouté un mécanisme de rétroaction, qui repère la direction exacte du rayonnement solaire par rapport à la direction dans laquelle est orienté le dispositif, et qui corrige l'orientation du dispositif.

L'utilisation de moteurs électriques présente toutefois des inconvénients. Dans le cas de centrales de très grande taille, par exemple de plusieurs dizaines d'hectares, les coûts d'installation, et notamment les coûts de câblage, sont élevés. Dans le cas de centrales de petite taille, par exemple pour des centrales de quelques dizaines ou centaines de mètres carrés, les risques de panne d'un moteur sont importants, et la centrale ne bénéficie pas nécessairement d'une équipe de maintenance présente sur place. De plus, les moteurs électriques exigent une alimentation que la centrale ne peut pas fournir directement. Elle doit donc être raccordée au réseau électrique non seulement comme un producteur, mais également comme un point de consommation, ou être équipée d'une batterie.

Le document JP 56162351 montre, par example, un dispositif de concentration de radiations solaires suivant le préambule de la revendication 1.

On connaît également des dispositifs agencés de sorte que les radiations solaires amènent le récepteur au point focal du concentrateur, tel que par exemple le dispositif par orientation du concentrateur à l'aide d'un déplacement de fluide par évaporation décrit dans le document US 4,476,854.

Ces dispositifs utilisent toutefois des appareils dont la fiabilité à long terme est limitée et dont les coûts sont importants.

L'invention vise à remédier à ces inconvénients.

Elle propose un dispositif automatique de concentration de radiations solaires, fiable et peu onéreux, directement mu par le soleil, et ne nécessitant pas de moteur électrique.

L'invention a ainsi pour objet un dispositif de concentration de radiations solaires , suivant l'objet de la revendication 1.

Dans certains modes de réalisation, le dispositif de pointage est séparé du dispositif de concentration principal, dont il assure l'orientation. Dans ce cas, la zone de concentration du dispositif de pointage est amenée à une position d'équilibre qui n'est pas directement celle du récepteur principal, mais qui assure que ce récepteur est au point de concentration du dispositif principal. Ceci est obtenu par un couplage mécanique entre le dispositif de pointage et le dispositif de concentration principal.

La position d'équilibre de la zone de concentration est stable, car un déplacement de la zone de concentration de radiations solaires depuis le récepteur vers un voisinage du récepteur provoque une déformation de l'élément thermo-déformable entraînant un rapprochement de la zone vers le récepteur.

Ainsi, grâce à la présence des éléments thermo-déformables, le dispositif permet de concentrer les radiations solaires sur l'extrémité (les extrémités) des éléments thermo-déformables, sur le récepteur. Le dispositif est conçu pour que, en présence de radiations solaires, le seul état stable soit celui où les radiations sont concentrées sur le récepteur.

On notera que le système de pointage des radiations solaires sur le récepteur est purement passif, car il ne nécessite aucune alimentation énergétique ni aucun moteur. Le nombre de pièces mobiles est également réduit à son minimum. Ceci permet une réduction des coûts de fabrication et de maintenance, et élimine toute opération de réglage après la fabrication du dispositif. On notera également que la position du système de pointage des radiations solaires sur le récepteur ne dépend pas de la température générale ni de l'intensité des radiations solaires, mais uniquement de la position de la zone de concentrations des radiations solaires.

Le déplacement de la zone de concentration peut être directement assuré par la déformation seule des éléments thermo-déformables, et/ou par le déplacement des moyens de concentration via par exemple des moyens de liaison de type moyens de démultiplication entre le ou les éléments thermo-déformables et les moyens de concentration.

Conformément à une première solution générale, le récepteur est relié à deux éléments thermo-déformables, chaque élément thermo-déformable étant apte, sous l'action d'une élévation de température, à déplacer le récepteur dans une direction opposée à celle dans laquelle le récepteur est déplacé lorsque l'autre élément thermo-déformable est soumis à une élévation de température.

Ainsi, selon cette première solution générale, on utilise deux éléments thermo-déformables montés de telle sorte qu'ils agissent en sens inverse. Leurs éléments sensibles au rayonnement sont montés bout à bout.

Le principe de fonctionnement du dispositif est le suivant. En dehors de la position d'équilibre, les radiations solaires sont concentrées sur l'un des éléments thermo-déformables, qui se déforme alors. Le changement relatif de forme des deux éléments déplace soit le récepteur seul, soit à la fois le récepteur et les moyens de concentration. Ce mouvement ne cesse que lorsque le rayonnement concentré frappe également l'autre élément thermo-déformable, dont l'action contrecarre alors celle du premier. La géométrie du dispositif d'orientation est conçue de manière à ce qu'à l'équilibre le récepteur soit situé au point focal des moyens de concentration. A l'équilibre, les deux éléments thermo-déformables sont éclairés, éventuellement dans des proportions différentes.

Ainsi, dans un mode de réalisation, le récepteur est relié à deux éléments thermo-déformables aptes à se contracter sous l'action d'une élévation de température, l'une des extrémité des éléments thermo-déformables étant fixe, l'autre extrémité étant reliée au récepteur.

Dans un autre mode de réalisation, le récepteur est relié à deux éléments thermo-déformables aptes à se dilater sous l'action d'une élévation de température, l'une des extrémités des éléments thermo-déformables étant fixe, l'autre extrémité étant reliée au récepteur, ainsi qu'aux moyens de concentration via un mécanisme de démultiplication.

Les éléments thermo-déformables peuvent être dans ce cas des cartouches à dilatation de gaz ou de cire.

Dans le cas où le ou les éléments thermo-déformables sont aptes à se contracter sous l'action d'une élévation de température, chaque élément thermo-déformable est un bilame.

Le bilame comprend avantageusement un élément de métal central présentant une forme ondulée, et dont les sommets des ondulations sont recouverts d'un métal de coefficient de dilatation plus élevé que celui de l'élément de métal central.

Le système de transmission peut comprendre un câble et une poulie. Il peut également comprendre une ou plusieurs tringles. D'autres modes de transmission pourront être facilement conçus par l'homme du métier, comme par exemple un couplage par des biellettes.

Pour compenser l'élasticité des éléments thermo-déformables, la distance entre les moyens de concentration et les éléments thermo-déformables est avantageusement supérieure à la distance entre les moyens de concentration et le récepteur.

Le déplacement de la zone de concentration peut être monodirectionnel ou bidirectionnel.

D'autres caractéristiques et avantages de la présente invention apparaîtront plus clairement à la lecture de la description suivante, donnée à titre d'exemple illustratif et non limitatif, et faite en référence aux dessins annexés sur lesquels :
- la figure 1 illustre schématiquement un dispositif de concentration de radiations solaires selon l'invention, conformément à un premier mode de réalisation,
- la figure 2 illustre schématiquement un dispositif selon l'invention, conformément à une variante du premier mode de réalisation,
- la figure 3 illustre schématiquement un dispositif selon l'invention, conformément à un deuxième mode de réalisation,
- les figures 4 et 5 illustrent schématiquement un dispositif selon l'invention, conformément à un troisième mode de réalisation,
- la figure 6 illustre schématiquement un dispositif selon l'invention, conformément à un quatrième mode de réalisation,
- les figures 7 à 10 illustrent schématiquement un dispositif selon l'invention, conformément à un cinquième mode de réalisation,
- la figure 11 illustre schématiquement un dispositif selon l'invention, conformément à une variante du cinquième mode de réalisation,
- les figures 12 et 13 illustrent schématiquement un dispositif selon l'invention, conformément à un sixième mode de réalisation, et
- la figure 14 illustre schématiquement différentes étapes d'un mode de fabrication d'un bilame pouvant être utilisé dans un dispositif selon l'invention.

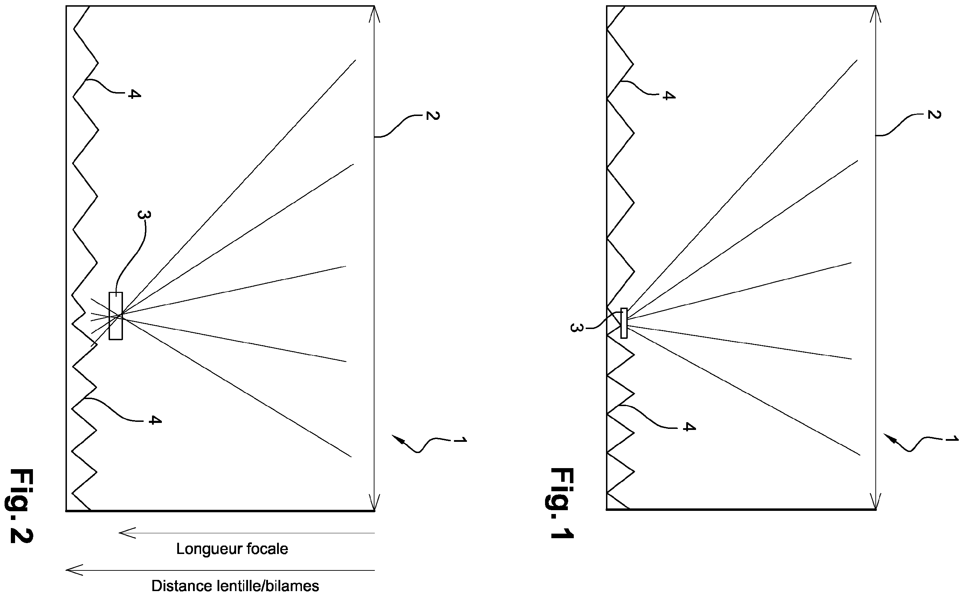

Le dispositif 1 de concentration de rayons solaires, tel qu'illustré à la figure 1, comprend une lentille 2, qui peut être une lentille classique ou une lentille de Fresnel, et un récepteur 3 relié à deux bilames 4. Les bilames 4 sont conçus de telle sorte que leur longueur diminue lorsqu'ils sont chauffés. Ces bilames 4 sont de bons conducteurs thermiques, de sorte qu'il suffit de les chauffer intensément sur une portion pour obtenir un raccourcissement significatif de leur longueur totale.

Dans ce mode de réalisation, le pointage de la zone de concentration sur le récepteur 3 s'effectue par translation du récepteur 3 le long du plan focal de la lentille 2. Les deux bilames 4 sont reliés au centre, ce centre étant solidaire du récepteur 3. Les deux autres extrémités des bilames 4 sont fixes. Le bilame 4 de droite est illuminé, tandis que le bilame 4 de gauche est faiblement illuminé.

En pratique, l'élasticité des bilames 4 existe. Il est souhaitable de compenser cette élasticité. Dans une variante du premier mode de réalisation, on recherche un éclairage inégal des deux bilames 4.

Pour gérer cette inégalité de manière précise, on peut utiliser une géométrie telle que le récepteur 3 est au point focal alors que l'un des bilames 4 reçoit plus de rayonnement que l'autre. Il suffit pour cela que le déplacement du récepteur 3 soit moins important que le déplacement du dispositif de pointage, dans une proportion qui tient compte de l'élasticité. C'est par exemple le cas si, dans une première variante, tel qu'illustré à la figure 2, la distance entre la lentille 2 et les bilames 4 est supérieure à la longueur focale de la lentille 2, c'est-à-dire à la distance entre la lentille 2 et le récepteur 3.

Pour obtenir une meilleure précision de pointage, on pourra également avantageusement disposer les extrémités des bilames 4 à l'endroit où ils sont reliés, en dehors du plan focal du dispositif d'orientation. Le rayonnement solaire sera ainsi réparti plus précisément entre les deux bilames 4 quand le dispositif est au point d'équilibre, car l'image du soleil est légèrement étalée. Ceci assure également un déplacement plus important du point de jonction entre les bilames 4 que du récepteur 3, comme dans la solution décrite ci-dessus.

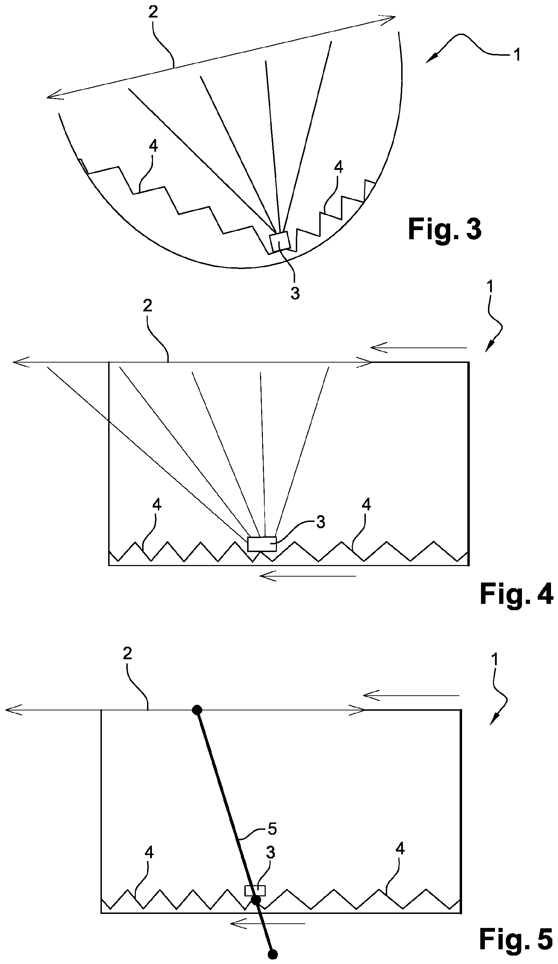

Dans un deuxième mode de réalisation, tel qu'illustré à la figure 3, sur laquelle les éléments identiques à ceux de la figure 1 portent les mêmes références, une extrémité de chaque bilame 4 est fixe, et les deux bilames 4 sont raccordés par leur autre extrémité, qui est par ailleurs solidaire d'un dispositif d'orientation circulaire. On utilise deux bilames 4 qui se raccourcissent sous l'action de la température.

Ce mode de réalisation est la transposition du premier mode de réalisation au cas d'une orientation par rotation.

Dans un troisième mode de réalisation, on utilise deux éléments thermo-déformables qui se dilatent avec la chaleur. On peut par exemple utiliser des cartouches à gaz ou à cire, ou des bilames qui se dilatent avec la chaleur.

Dans ce mode de réalisation, tel qu'illustré à la figure 4, les extrémités de deux cartouches 4 sont fixes. Les deux cartouches 4 sont reliées au centre, ce centre étant solidaire du récepteur 3 ainsi que de la lentille 2. L'allongement d'une cartouche 4 déplace donc la lentille 2 du côté opposé à celui où le soleil est initialement focalisé. A l'équilibre, la lumière est concentrée au point de jonction des deux cartouches 4, qui est également le point où se trouve le récepteur 3. La cartouche 4 de droite est illuminée, tandis que la cartouche 4 de gauche est peu illuminée.

Pour des raisons géométriques, la lentille 2 doit se déplacer plus que le récepteur 3, de manière à ce que le déplacement relatif des deux éléments ait un effet sur la focalisation. Ceci peut être assuré par un mécanisme de démultiplication, comme par exemple un levier 5, tel qu'illustré à la figure 5. Le levier 5 est fixé à la lentille 2 ainsi qu'au point de jonction entre les cartouches 4.

Les variantes décrites pour le premier mode de réalisation s'appliquent également à ce mode de réalisation.

Un avantage de ce troisième mode de réalisation est que les cartouches sont des dispositifs bien connus, qui sont par exemples utilisés pour la réalisation de robinets thermostatiques. Ces dispositifs sont peu coûteux, fiables et précis.

On pourra avantageusement utiliser des cartouches contenant un gaz liquide, c'est-à-dire un gaz qui se liquéfie aux températures ambiantes, et se vaporise lors du chauffage. On remplace alors un effet proportionnel à la température par une augmentation de volume provoquée par le seul fait d'être chauffé, proportionnelle au temps d'éclairement. De telles cartouches présentent une très faible élasticité apparente comparée aux forces produites par l'augmentation de température. Ces cartouches permettent également un bon transfert de chaleur en leur sein, ce qui est favorable à des modifications importantes de longueur.

On pourra également utiliser des cartouches à faible débattement, couplées à une lentille de faible longueur focale. Dans ce cas, on pourra utiliser une démultiplication entre le récepteur et le concentrateur. Ce mode de réalisation pourra par exemple être utilisé pour l'orientation de concentrateurs cylindro-paraboliques ou de type lentille de Fresnel de grande taille, tels que ceux utilisés pour les centrales de grande puissance.

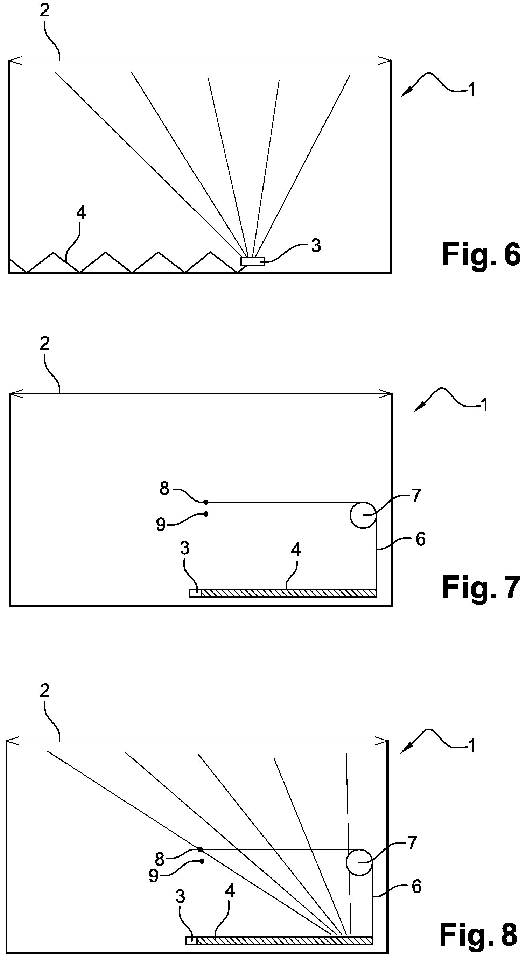

Dans un quatrième mode de réalisation, ne faisant pas partie de l'invention, tel qu'illustré à la figure 6, on utilise un unique élément thermo-déformable qui se raccourcit sous l'action de la température, par exemple un bilame 4. Le récepteur 3 est positionné à l'extrémité du bilame 4. Au repos, le bilame 4 est allongé au maximum. Dès qu'il est éclairé, il se raccourcit, jusqu'au moment où il ne reçoit plus le rayonnement solaire qu'à son extrémité. La position d'équilibre stable est ainsi celle où la lumière est focalisée sur l'extrémité du bilame 4.

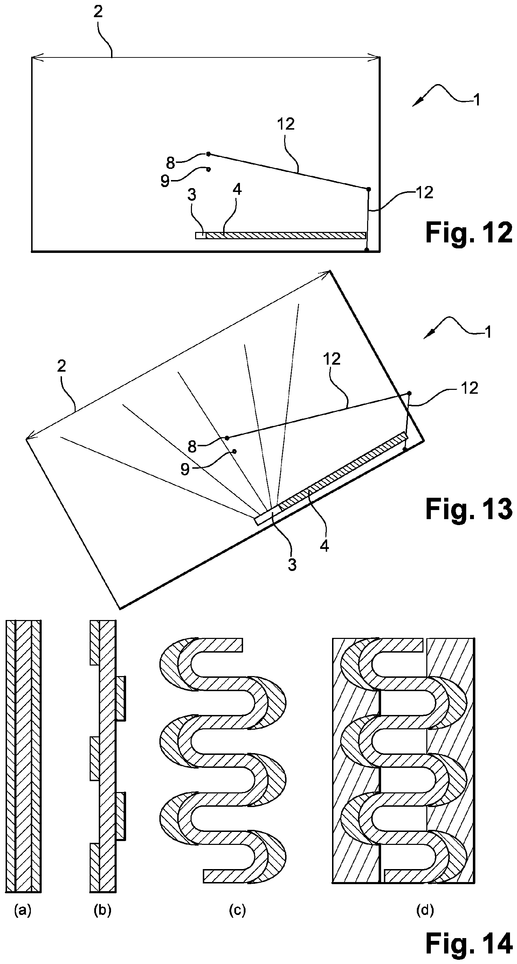

Dans une variante de ce mode de réalisation, ne faisant non plus pas partie de l'invention, tel qu'illustré aux figures 12 et 13, on utilise une cartouche 4 à gaz liquéfié. Dès que la cartouche 4 est chauffée par la lumière focalisée, le liquide se volatilise et la longueur de la cartouche 4 augmente. Cet allongement entraîne une modification de l'orientation. Ce phénomène cesse quand la lumière concentrée atteint l'extrémité de la cartouche 4. Le montage est construit de telle sorte que le récepteur 3 soit alors au point de focalisation. Les figures 12 et 13 illustrent ce mode de réalisation, dans le cas d'une orientation par rotation à l'aide de biellettes 12. La figure 12 montre la position initiale de la cartouche 4, avant allongement, tandis que la figure 13 montre la position finale de la cartouche 4.

En règle générale, on concevra avec un soin particulier l'extrémité du dispositif thermo-modifiable, afin d'assurer que le point d'équilibre soit aussi stable et précis que possible.

On peut également plus généralement concevoir des modes de réalisation impliquant une rotation des moyens de concentration. A moins que l'axe de rotation soit vertical, il est avantageux de prévoir que cet axe passe par le centre de gravité du dispositif selon l'invention. En effet, cet alignement réduit l'effort que le dispositif de pointage doit fournir, et rend inutile une correction des effets de la gravité par une modification de la géométrie du dispositif de pointage. Un de ces modes va maintenant être décrit.

Dans ce cinquième mode de réalisation, ne faisant pas partie de l'invention, tel qu'illustré sur les figures 7 à 10, on utilise un unique bilame 4 qui se courbe sous l'effet d'une augmentation de température. Dans ce mode de réalisation, on a choisi une orientation par rotation, portant sur l'ensemble du dispositif de pointage, et non sur le seul récepteur 3.

Le bilame 4 est fixé au centre du dispositif d'orientation qui est la position du récepteur 3. L'autre extrémité du bilame 4 se situe au-delà du point le plus éloigné que le rayonnement solaire peut atteindre. Le rayonnement chauffe un point particulier du bilame 4, qui se courbe. Ceci entraîne, par un système de transmission mécanique, la rotation du dispositif de pointage.

Pour simplifier, les figures 7 à 10 utilisent une transmission par un câble 6 attaché à un point fixe externe 8 et une poulie 7, la poulie 7 étant solidaire de l'axe de rotation 9 du dispositif 1. D'autres solutions sont possibles, par exemple le remplacement du câble 6 et de la poulie 7 par une tringle et un levier, ou par un système avec des engrenages.

Le chauffage du bilame 4 entraîne sa déformation, qui à son tour entraîne une rotation du dispositif de pointage et donc un déplacement du point de chauffage. Ce déplacement induit une plus grande action du bilame 4, car la déformation s'applique à une longueur plus importante du bilame 4. La seule position stable est celle où le rayonnement est focalisé sur l'extrémité du bilame 4.

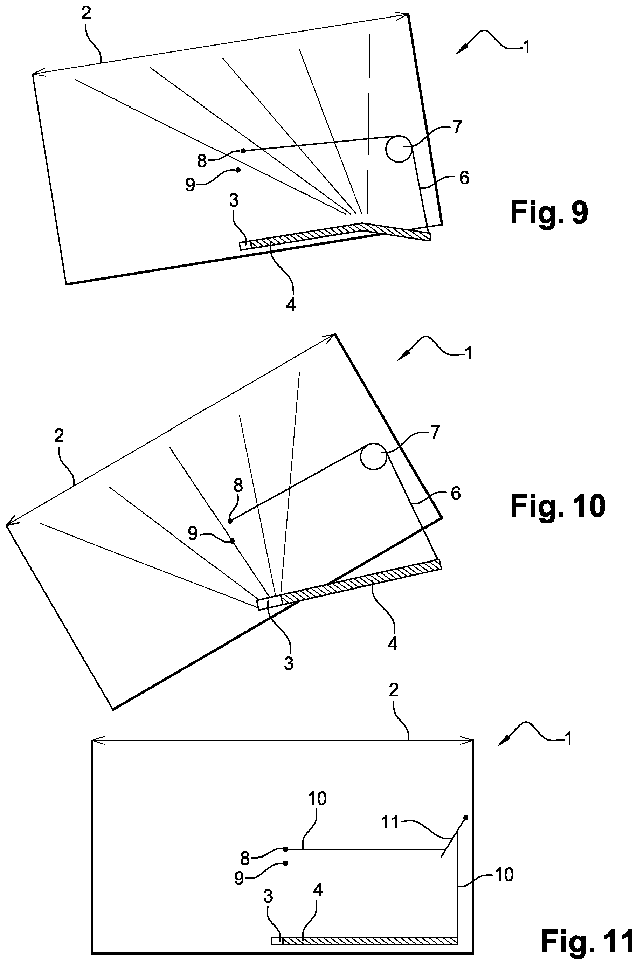

La figure 8 illustre la position initiale du dispositif 1, avant la courbure du bilame 4. La figure 9 une position intermédiaire, où le bilame 4 est courbé, et la figure 10 illustre la position finale, lorsque le rayonnement est focalisé sur le récepteur 3.

Dans une variante, qui ne fait pas partie de l'invention, de ce mode de réalisation, tel qu'illustré à la figure 11, la transmission de la courbure du bilame est réalisée à l'aide de deux tringles de renvoi 10 coopérant avec une biellette 11.

Pour davantage de clarté, on pourra se limiter, dans les explications qui suivent, au cas d'un dispositif tournant autour d'un axe horizontal, orienté est-ouest.

Au repos, il est préféré d'incliner le dispositif sous un angle qui dépend de la latitude. On pourra concevoir le dispositif de telle sorte que, sous cet angle, l'extrémité du bilame soit éclairée au lever du jour. Il suffit pour cela que la longueur du bilame soit supérieure à la distance focale divisée par la tangente de l'angle au repos, l'angle étant mesuré par rapport à l'horizontale. Il sera généralement utile d'éviter que l'angle au repos soit supérieur à l'inclinaison maximale du soleil par rapport à l'horizontale.

Cette précision s'applique également aux autres modes de réalisation.

Dans le cas d'une transmission par câble et poulie, le retour du dispositif à sa position de repos pourra avantageusement être assuré par son poids, pour peu que son centre de gravité ne soit pas sur l'axe de rotation. Dans ce cas, la position de repos pourra être assurée par une butée. Dans le cas d'une transmission plus rigide, comme une tringle, le centre de gravité pourra avantageusement être sur l'axe de rotation.

Certains des modes de réalisation décrits ci-dessus utilisent des bilames qui se raccourcissent quand leur température augmente. Il est également avantageux que les bilames aient une faible élasticité et une grande capacité d'allongement. On pourra pour cela utiliser des bilames ayant une forme de ressort.

Une manière de les fabriquer facilement consiste, tel qu'illustré à la figure 14, à utiliser une plaque d'un métal à faible coefficient de dilatation, puis à le recouvrir sur ses deux faces d'un métal de plus grand coefficient de dilatation (étape (a)). On usine alors les deux faces alternativement, de manière à ce que la plaque centrale soit recouverte du second matériau tantôt à droite, tantôt à gauche (étape (b)). Il ne reste plus alors qu'à former la plaque sous la forme d'un soufflet, chaque coude étant recouvert du second matériau isolant sur sa face extérieure (étape (c)).

On pourra également prévoir une isolation de certaines faces du ressort, afin d'en augmenter la déformation (étape (d)). On prendra soin que cette isolation ne limite pas l'arrivée de la lumière, ni n'augmente excessivement la rigidité du bilame.

On pourra également prévoir une surface réfléchissante, derrière le bilame, ou plus généralement derrière l'élément thermo-modifibale, voire autour de ses faces latérales, de manière à augmenter l'effet de la focalisation.

Les modes de réalisation décrits ci-dessus sont des cas de pointage selon un seul axe. L'homme du métier n'aura aucune difficulté à imaginer et construire des dispositifs de pointage bidirectionnels utilisant, pour chaque dimension ou pour une seule d'entre elles, les caractéristiques de l'invention.

Les modes de réalisation décrits ci-dessus sont par ailleurs adaptés à une concentration des radiations solaires par réfraction. L'homme du métier pourra les transposer sans difficulté à une concentration par réflexion, par exemple en utilisant des réflecteurs paraboliques classiques ou des réflecteurs dits de Fresnel.

Certains dispositifs de concentration sont composés d'éléments plus petits, répartis de manière répétitive dans un plan, et formant un module de production. Le dispositif de pointage peut être prévu pour orienter l'ensemble du module, si celui-ci forme un tout mécaniquement solidaire.

Alternativement, on pourra, dans le cas où les moyens de concentration sont individuellement orientables, prévoir soit un dispositif de pointage unique entraînant le déplacement de tous les moyens de concentration, soit un dispositif de pointage par moyen de concentration.

Une réalisation particulièrement avantageuse utilise cette dernière configuration. Des dispositifs de concentration par réfraction utilisent des lentilles, pouvant être semi-cylindriques normales ou de Fresnel, dont chacune focalise la lumière solaire sur une ligne située dans leur plan focal. Ces dispositifs de concentration sont disposés horizontalement et pivotent autour d'un axe horizontal, orienté est-ouest, passant par leur centre de gravité. Chaque dispositif comprend à son extrémité un dispositif de pointage.

Dans cette réalisation, la disposition horizontale des dispositifs de concentration permet une exploitation optimale du soleil le matin et le soir. Les dispositifs de concentration sont avantageusement assemblés en un module, orienté selon une direction générale est-ouest, et qui est incliné par rapport à l'horizontale d'environ 30°. Une telle disposition collecte le maximum de rayonnement, pour un coût minimal du dispositif de pointage. Elle pourra être utilisée pour alimenter des cellules photovoltaïques.

Une autre réalisation avantageuse consiste à utiliser des dispositifs de pointage pour faire pivoter des miroirs, par exemple des miroirs cylindro-paraboliques ou des miroirs de Fresnel, qui focalisent le rayonnement solaire sur un tube contenant un fluide caloporteur. Compte tenu de la masse des miroirs cylindro-paraboliques pour les centrales de grande puissance, on pourra préférer l'utilisation de cartouches, capables de développer une force importante. On pourra utiliser, comme cela a été indiqué plus haut, un dispositif de démultiplication.

En règle générale, et quel que soit le mode de réalisation, la précision du dispositif de pointage dépend de la forme et des caractéristiques d'absorption des surfaces des éléments thermo-déformables qui reçoivent le rayonnement solaire, tout particulièrement aux alentours du point où ces éléments sont reliés (pour les dispositifs à deux éléments thermo-modifiables). Elle dépend également des caractéristiques de conduction thermique des éléments thermo-déformables, ainsi que des caractéristiques de conduction thermique d'un des éléments vers l'autre. On pourra également avantageusement prévoir une isolation thermique des surfaces qui ne sont pas destinées à absorber le rayonnement, par exemple sous la forme d'une mousse sur les faces latérales et la partie inférieure des bilames, ou d'un choix de matériaux adaptés pour les cartouches.

Pour améliorer la précision, on pourra utiliser un pointage en deux temps. Dans ce cas, un premier dispositif donnera la direction générale, et un second dispositif assurera la précision. Un mode de réalisation consiste à assurer un pointage général par des solutions traditionnelles de moteurs électriques, puis un pointage final conformément à l'invention. Un autre mode de réalisation consiste à utiliser un dispositif selon l'invention pour les deux étapes de pointage.

## Revendications

1. Dispositif (1) de concentration de radiations solaires, comprenant des moyens de concentration (2) aptes à concentrer des radiations solaires sur une zone de concentration, et un récepteur (3) de radiations solaires, le récepteur (3) étant relié à deux éléments susceptible de se déformer sous l'action de la température, appelé élément thermo-déformable, **caractérisé en ce que** les éléments thermodéformables étant choisis parmi :
- deux bilames (4), chaque bilame (4) étant apte, sous l'action d'une élévation de température, à déplacer le récepteur (3) dans une direction opposée à celle dans laquelle le récepteur (3) est déplacé lorsque l'autre bilame est soumis à une élévation de température, les deux bilames (4) étant aptes à se contracter sous l'action d'une élévation de température, l'une des extrémités des bilames (4) étant fixe, l'autre extrémité étant reliée au récepteur(3),
- deux bilames (4) aptes à se dilater sous l'action d'une élévation de température, chaque bilame (4) étant apte, sous l'action d'une élévation de température, à déplacer le récepteur (3) dans une direction opposée à celle dans laquelle le récepteur (3) est déplacé lorsque l'autre bilame est soumis à une élévation de température, les moyens de concentration comprenant une lentille (2), l'une des extrémité des bilames (4) étant fixe, l'autre extrémité étant reliée au récepteur (3) ainsi qu'à la lentille (2) via un levier (5) fixé à la lentille (2) ainsi qu'au point de jonction entre les bilames (4),
chaque élément thermo-déformable étant apte, lorsque les radiations issues des moyens de concentration sont concentrées sur une zone de concentration située sur ledit élément thermo-déformable, à changer de forme de manière à entraîner un déplacement de la zone de concentration en direction du récepteur ou du récepteur en direction de la zone de concentration, de sorte que le dispositif permet, pour une position du soleil donnée, et sous l'action des radiations solaires, un déplacement de zone de concentration depuis une position initiale située sur un élément thermo-déformable jusqu'à une position d'équilibre finale située sur le récepteur.

2. Dispositif (1) selon la revendication 1, **caractérisé en ce que** chaque bilame (4) comprend un élément de métal central présentant une forme ondulée, et dont les sommets des ondulations sont recouverts d'un métal de coefficient de dilatation plus élevé que celui de l'élément de métal central.

3. Dispositif (1) selon la revendication 1 ou 2, **caractérisé en ce que** la distance entre les moyens de concentration (2) et les éléments thermo-déformables (4) est supérieure à la distance entre les moyens de concentration (2) et le récepteur (3).

4. Dispositif (1) selon l'une des revendications 1 à 3, **caractérisé en ce que** le déplacement de la zone de concentration est monodirectionnel ou bidirectionnel.

## Patentansprüche

1. Vorrichtung (1) zur Konzentration der Sonneneinstrahlung, umfassend Konzentrationsmittel (2), die imstande sind, Sonneneinstrahlung in einer Konzentrationszone zu konzentrieren, und einen Empfänger (3) von Sonneneinstrahlung, wobei der Empfänger (3) mit zwei Elementen verbunden ist, die imstande sind, sich unter der Wirkung der Temperatur zu verformen, bezeichnet als thermisch verformbares Element, **dadurch gekennzeichnet, dass** die thermisch verformbaren Elemente (4) ausgewählt sind aus:
- zwei Bimetallen (4), wobei jedes Bimetall (4) imstande ist, unter der Wirkung einer Temperaturerhöhung den Empfänger (3) in eine Richtung zu verlagern, die der entgegengesetzt ist, in welcher der Empfänger (3) verlagert wird, wenn das andere Bimetall einer Temperaturerhöhung ausgesetzt wird, wobei die zwei Bimetalle (4) imstande sind, sich unter der Wirkung einer Temperaturerhöhung zusammenzuziehen, wobei eines der Enden der Bimetalle (4) fest ist, wobei das andere Ende mit dem Empfänger (3) verbunden ist,
- zwei Bimetallen (4), die imstande sind, sich unter der Wirkung einer Temperaturerhöhung auszudehnen, wobei jedes Bimetall (4) unter der Wirkung einer Temperaturerhöhung imstande ist, den Empfänger (3) in eine Richtung zu verlagern, die der entgegengesetzt ist, in welcher der Empfänger (3) verlagert wird, wenn das andere Bimetall einer Temperaturerhöhung ausgesetzt wird, wobei die Konzentrationsmittel eine Linse (2) umfassen, wobei eines der Enden der Bimetalle (4) fest ist, wobei das andere Ende mit dem Empfänger (3) sowie mit der Linse (2) über einen an der Linse (2) befestigten Hebel (5) sowie am Verbindungspunkt zwischen den Bimetallen (4) verbunden ist,
wobei jedes thermisch verformbare Element (4) imstande ist, wenn die Strahlungen aus den Konzentrationsmitteln auf eine Konzentrationszone auf dem thermisch verformbaren Element konzentriert werden, die Form derart zu ändern, dass eine Verlagerung der Konzentrationszone in Richtung des Empfängers oder des Empfängers in Richtung der Konzentrationszone derart erfolgt, dass die Vorrichtung für eine bestimmte Sonnenposition und unter der Wirkung der Sonneneinstrahlung eine Verlagerung der Konzentrationszone von einer Ausgangsposition, die sich auf einem thermisch verformbaren Element befindet, bis zu einer finalen Ausgleichsposition, die sich auf dem Empfänger befindet, erlaubt.

2. Vorrichtung (1) nach Anspruch 1, **dadurch gekennzeichnet, dass** das Bimetall (4) ein zentrales Metallelement umfasst, das eine wellige Form aufweist und dessen Wellenspitzen mit einem Metall mit einem höheren Ausdehnungskoeffizienten bedeckt sind als der des zentralen Metallelements.

3. Vorrichtung (1) nach Anspruch 1 oder 2, **dadurch gekennzeichnet, dass** der Abstand zwischen den Konzentrationsmitteln (2) und den thermisch verformbaren Mitteln (4) größer als der Abstand zwischen den Konzentrationsmitteln (2) und dem Empfänger (3) ist.

4. Vorrichtung (1) nach einem der Ansprüche 1 bis 3, **dadurch gekennzeichnet, dass** die Verlagerung der Konzentrationszone eindirektional oder zweidirektional ist.

## Claims

1. A device (1) for concentrating solar radiation, including concentrating means (2) capable of concentrating solar radiation on a concentration zone, and a solar radiation receiver (3), the receiver (3) being connected to two elements capable of deforming under the action of the temperature, called thermo-deformable element, **characterized in that** the thermal-deformable elements being chosen from among:
- two thermal switches (4), each thermal switch (4) being able, under the action of the temperature increase, to move the receiver (3) in a direction opposite that in which the receiver (3) is moved when the other thermal switch is subject to a temperature increase, the two thermal switches (4) being able to contract under the action of a temperature increase, one of the ends of the thermal switches (4) being stationary, the other end being connected to the receiver (3),
- two thermal switches (4) able to expand under the action of the temperature increase, each thermal switch (4) being able, under the action of the temperature increase, to move the receiver (3) in a direction opposite that in which the receiver (3) is moved when the other thermal switch is subject to a temperature increase, the concentrating means including a lens (2), one of the ends of the thermal switches (4) being stationary, the other end being connected to the receiver (3) as well as to the lens (2) via a lever (5) fastened to the lens (2) as well as to the junction point between the thermal switches (4),
each thermo-deformable element being able, when the radiation from the concentrating means is concentrated on a concentration zone located on said thermo-deformable element, to change shape so as to cause a movement of the concentration zone toward the receiver or from the receiver toward the concentration zone, such that the device allows, for a given position of the sun, and under the action of the solar radiation, a movement of the concentration zone from an initial position located on a thermo-deformable element to a final equilibrium position located on the receiver.

2. The device (1) according to claim 1, **characterized in that** each thermal switch (4) includes a central metal element having an undulated shape, and whereof the apices of the undulations are covered with a metal having an expansion coefficient higher than that of the central metal element.

3. The device (1) according to claim 1 or 2, **characterized in that** the distance between the concentrating means (2) and the thermo-deformable elements (4) is greater than the distance between the concentrating means (2) and the receiver (3).

4. The device (1) according to one of claims 1 to 3, **characterized in that** the movement of the concentration zone is one-way or two-way.
